# EUROPEAN PATENT APPLICATION

(11) **EP 1 707 968 A1**
(43) Date of publication of application: **04.10.2006**
(21) Application number: 05104547.4
(22) Date of filing: 27.05.2005
(51) Int. Cl.: G01R 29/08, G01N 22/00

(54) **Electromagnetic field probe**

(30) Priority: 31.03.2005 JP 2005105182
(71) Applicant: Kabushi Kaisha Toshiba, Tokyo 105-8001 (JP)
(72) Inventor: Suzuki, Hiromichi Toshiba Corporation, Minato-ku Tokyo (JP); Amano, Takashi Toshiba Corporation, Minato-ku Tokyo (JP); Minemura, Takashi Toshiba Corporation, Minato-ku Tokyo (JP); Mizoguchi, Satoshi Toshiba Corporation, Minato-ku Tokyo (JP); Sato, Koichi Toshiba Corporation, Minato-ku Tokyo (JP)
(74) Representative: Henkel, Feiler & Hänzel

(57) **Abstract**

There is provided an electromagnetic field probe (1) having an antenna (11), a dielectric member (14) attached around the antenna (11), and an electromagnetic wave absorbing member (16) attached around the dielectric member (14). An electromagnetic wave "U0" coming into the electromagnetic field probe (1) from a lower base of the cylindrical dielectric member (14) and directly reaching the antenna (11) is sensed by the antenna (11). Another electro-magnetic wave "U1" passing by the antenna (11) reaches an inter-face (14b), loses a part of its energy due to magnetic loss caused by the electromagnetic wave absorbing member (16), and produces a reflected wave "U2" of a reduced electromagnetic field strength. Measuring an electromagnetic field strength of the wave "U0" is not affected much by the reflected wave "U2".

## Description

### Technical Field

The present invention relates to an electromagnetic field probe con-figured to measure electromagnetic field strengths.

### Background Art

There is known a conventional electromagnetic field probe formed by an antenna and a dielectric member attached around the antenna. The antenna may be of, e.g. a monopole type or a loop type. Measuring electromagnetic field strengths accurately by such an electromagnetic field probe may often be disturbed by noises coming into the electromagnetic field probe, or by total reflections of electromagnetic waves coming into the electromagnetic field probe occurring at an inter-face between the dielectric member and the outside of the electromagnetic field probe..

There is known another conventional electromagnetic field probe giving directivity to an antenna thereof in order to shield incoming noises by loading a metallic horn to the antenna or by loading dielectric members in directions other than a particular direction. This conventional electromagnetic field probe is disclosed in Japanese Patent Publication of Unexamined Applications (Kokai), 2001-255347, the English version of which is available on a website named "Intellectual Property Digital Library" linked from the Japan Patent Office website.

The problem of total reflections, however, still remains unsolved by the above conventional electromagnetic field probe.

### Technical Problem and its Solution; Advantageous Effects

The problem of total reflections may be explained as follows. Assume an electromagnetic field probe including, e.g., a monopole antenna having two ends, and a dielectric member shaped like a cylinder and attached around the antenna. The one end of the antenna sticks out of an upper base of the cylindrical dielectric member and may be connected to a measuring instrument.

The other end of the antenna is covered by a lower base of the cylindrical dielectric member, and is electrically open. The side of the cylindrical dielectric member is an interface between the dielectric member and the outside of the electromagnetic field probe that is usually air.

Assume two electromagnetic waves of almost equal electromagnetic field strengths come from the outside through the lower base into the dielectric member. One of these waves reaches the antenna directly, and the other passes by the antenna and reaches the side of the cylindrical dielectric member. The latter wave may be to-tally reflected on the side depending on an angle of incidence, and may reach the antenna after being reflected with a phase different from that of the former wave.

Electromagnetic field strengths of the former wave and the latter reflected wave are added on the antenna in an algebraic manner so that a sum is sensed by the antenna. The latter reflected wave thus causes an error of measuring the electromagnetic field strength of the former wave by the electromagnetic field probe.

A phase difference between the former and the latter waves on the antenna is affected by the angle of incidence or a difference of path lengths of these waves, and so is the error of measuring the electromagnetic field strength. The error is thus affected by an attitude (inclination) or a size of the electromagnetic field probe, and causes such a measurement to be inaccurate, unstable or unrepeatable, particularly when the electromagnetic field probe is small-sized, or is used while being moved.

Consequently it is difficult to measure electromagnetic field strengths with a conventional, particularly small-sized electromagnetic field probe in an accurate, stable and repeatable manner. In real situations where more than two electromagnetic waves may come into the electromagnetic field probe or some multiple reflections may occur, the above problem caused by total reflections may be even worse. An electromagnetic field probe using another type of antennas (loop, di-pole, biconical and so forth) suffers from a same problem.

Accordingly, it is necessary to suppress total reflections of incident electromagnetic waves occurring within an electromagnetic field probe for measuring electromagnetic field strengths as accurately as possible.

According to a first aspect of the present invention, there is provided an electromagnetic field probe characterized by comprising an antenna, a dielectric member attached around the antenna, and an electromagnetic wave absorbing member attached around the dielectric member.

In accordance with the above aspect of the present invention, the electromagnetic wave absorbing member suppresses total reflections of incident electromagnetic waves on an interface of the dielectric member and the electromagnetic wave absorbing member, thus improving the accuracy, stability and repeatability of measuring electromagnetic field strengths.

### Brief Description of the Figures in the Drawings

FIG. 1 shows a section of an electromagnetic field probe of a first embodiment of the present invention.

FIG. 2 illustrates how to suppress total reflections on the interface between a dielectric member and an electromagnetic wave absorbing member of the electromagnetic field probe of the first embodiment.

FIG. 3 shows a section of an electromagnetic field probe of a second embodiment of the present invention.

FIG. 4 shows a section of another electromagnetic field probe of the second embodiment used for evaluating an effect of the present invention.

FIG. 5 shows a section of an electromagnetic field probe of a third embodiment of the present invention.

### Detailed Description of Embodiments

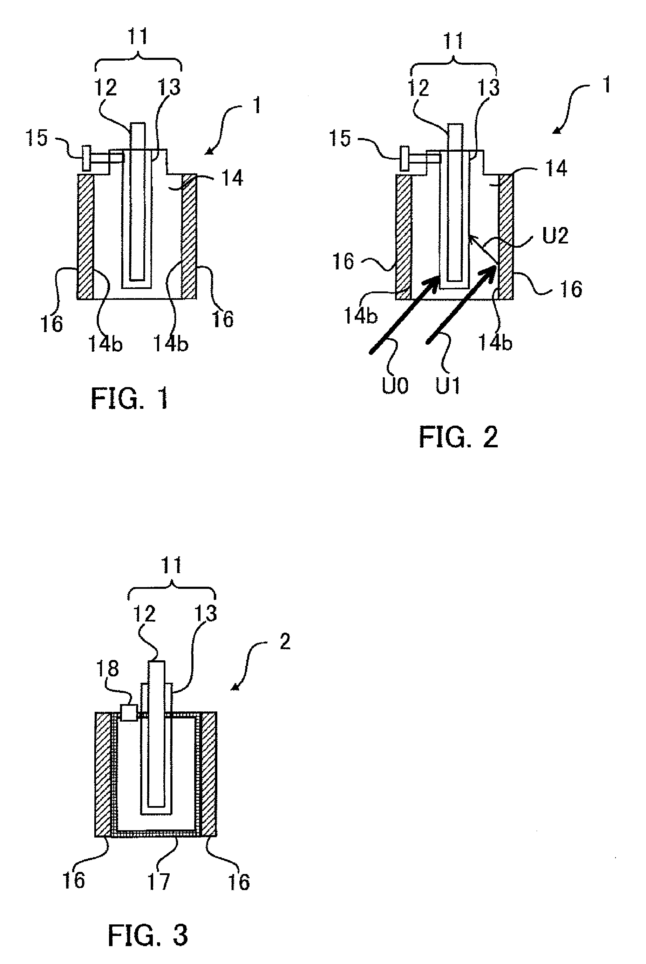

A first embodiment of the present invention will be described with reference to FIG. 1 and FIG. 2. FIG. 1 shows a section of an electromagnetic field probe 1 of the first embodiment. The electromagnetic field probe 1 has an antenna 11 formed by an antenna element 12 and a protecting member 13 covering the antenna element 12. The antenna element 12 may be, e.g., a monopole, dipole, loop or biconi-cal antenna.

The electromagnetic field probe 1 has a dielectric member 14 formed by a dielectric material. The dielectric member 14 is shaped almost like a cylinder. An upper end of the antenna element 12 sticks out of an upper base of the almost cylindrical dielectric member 14, and may be connected to a measuring instrument (not shown). A lower end of the antenna element 12 is covered by a lower base of the almost cylindrical dielectric member 14.

The dielectric member 14 is attached around the antenna 11 with a screw 15. Here, the term "around" means to exist 360 degrees around the antenna 11 on a plane parallel to the upper or the lower base of the almost cylindrical dielectric member 14. On the section shown in FIG. 1, the dielectric member 14 covers a lower part of the antenna 11.

The electromagnetic wave absorbing member 16 is attached around the dielectric member 14. Here, the term "around" means to exist 360 degrees around the dielectric member 14 on a plane parallel to the upper or the lower base of the almost cylindrical dielectric member 14. On the section shown in FIG. 1, the electromagnetic wave absorbing member 16 covers the side of the almost cylindrical dielectric member 14.

The electromagnetic field probe 1 has an electromagnetic wave absorbing member 16 attached around the dielectric member 14. An interface between the dielectric member 14 and the electromagnetic wave absorbing member 16 is given a reference numeral 14b. The electromagnetic wave absorbing member 16 is formed by a magnetic loss material like an electromagnetic wave absorbing sheet or a ferrite.

The electromagnetic wave absorbing member 16 may be configured including a plurality of multiple-layered magnetic loss materials, where a dielectric constant or a magnetic permeability of each layer is different to each other. The above multiple-layered configuration may contribute to developing a broader frequency range of the electromagnetic field probe 1.

The dielectric member 14 has a dielectric constant being no less than 22 and no greater than 81 at a frequency of three Gigahertz (GHz), and a conductivity being no greater than 2.4 at this frequency. The electromagnetic wave absorbing member 16 has a complex dielectric constant including a real part being no less than one in a frequency range from one Megahertz (MHz) to three GHz, and an imaginary part being no less than one in the above frequency range.

The electromagnetic wave absorbing member 16 has a complex magnetic permeability including a real part being no less than one and no greater than 100 in the above frequency range, and an imaginary part being no less than one and no greater than 50 in the above frequency range. These values of the complex dielectric constant and the complex magnetic permeability are based on a study including some experiments.

The dielectric member 14 may have a dielectric constant being no less than one and no greater than 88 (a value of water), and a conductivity being no greater than four (a value of seawater). The dielectric member 14 may be formed by a dielectric material which is practically usable in a frequency range from 1 MHz to several tens GHz.

The electromagnetic wave absorbing member 16 may have a real part of the complex magnetic permeability being no less than one and no greater than 100, and an imaginary part of the complex magnetic permeability being no less than zero and no greater than 50. The electromagnetic wave absorbing member 16 may be formed by a magnetic loss material which is practically usable in a frequency range from 1 MHz to several tens GHz.

How to suppress total reflections of incident electromagnetic waves on the interface 14b will be explained with reference to FIG. 2. Assume two electromagnetic waves "U0" and "U1" of almost equal electromagnetic field strengths come into the electromagnetic field probe 1 through the lower base of the dielectric member 14 as shown in FIG. 2. The electromagnetic wave "U0" reaches the antenna 11 directly and sensed by the antenna 11.

The electromagnetic wave "U1" passes by the antenna 11, reaches the interface 14b and loses a part of its energy as magnetic loss. The electromagnetic wave "U1" thus produces a reflected wave "U2" after being reflected on the interface 14b having a reduced electromagnetic field strength.

The reflected wave "U2" may reach the antenna 11 and may cause an error for measuring the electromagnetic field strength like the reflected wave in the conventional electromagnetic field probe earlier described. An effect of this error is, however, limited comparing to that of the conventional electromagnetic field probe as the electromagnetic field strength of the reflected wave "U2" has been reduced on the interface 14b.

The electromagnetic field strength of the direct wave "'U0" is sensed by the antenna 11 being affected little by the reflected wave "U2" in a case where the magnetic loss on the interface 14b is greater than needed. The stability and repeatability of measuring the electromagnetic field strength of "U0" may thus be improved by attaching the electromagnetic wave absorbing member 16. The above effect of improving the stability and repeatability may lead to improving the accuracy of measuring electromagnetic field strengths.

In real situations where more than two electromagnetic waves may come into the electromagnetic field probe 1 or some multiple reflections may occur at the interface 14b, the above effect of improving the accuracy may be similarly obtained.

The dielectric member 14 is attached around the antenna 11 with the screw and thus the antenna 11 may be variably placed relative to the dielectric member 14. The electromagnetic field probe 1 becomes more sensitive as the antenna 11 is placed lower relative to the dielectric member 14 in FIG. 2. This relation between the antenna 11 and the dielectric member 14 may be arranged considering an electromagnetic field strength or an angle of incidence of an electromagnetic wave coming into the electromagnetic field probe 1.

According to the first embodiment described above, the accuracy of measuring electromagnetic field strengths may be improved by using an electromagnetic field probe having an electromagnetic wave absorbing member attached around.

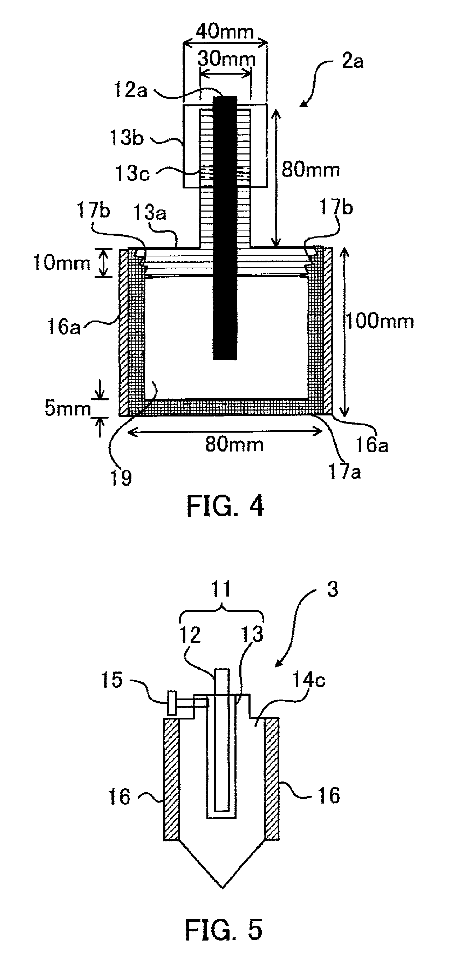

A second embodiment of the present invention will be described with reference to FIG. 3 and FIG. 4. FIG. 3 shows a section of an electromagnetic field probe 2 of the second embodiment. Each of the portions given the reference numerals 11, 12, 13 and 16 is a same as the corresponding one shown in FIG. 1, and its explanation is omitted.

The electromagnetic field probe 2 has a container 17 being attached to the antenna 11 and covering a lower part of the antenna 11. The container 17 is shaped almost like a hollow cylinder, and on an upper base has an injection hole 18 that may open and close. The electromagnetic wave absorbing member 16 is attached around the container 17.

The container 17 works as a dielectric member similar to the dielectric member 14 shown in FIG. 1 after being filled with dielectric liquid which may be injected from the injection hole 18 into the container 17. The electromagnetic field probe 2 is then configured similar to the electromagnetic field probe 1 of the first embodiment, and may be used for measuring electromagnetic field strengths.

The container 17 may be refilled with another kind of dielectric liquid that may be suitably selected according to a target or circumstances of measuring electromagnetic field strengths. This is an additional advantage of the second embodiment.

FIG. 4 shows a section of another electromagnetic field probe 2a of the second embodiment used for evaluating the effect of improving the measurement accuracy. The electromagnetic field probe 2a has an antenna element 12a and a protecting member 13a attached around the antenna element 12a. Above the protecting member 13a, there is a cap 13b screwed with the protecting member 13a via a screw portion 13c. The antenna element 12a may be placed up and down relative to the protecting member 13a up to about five centimeters while the screw of the screw portion 13c is being loosened.

The electromagnetic field probe 2a has a container 17a shaped like a hollow cylinder below the protecting member 13a. The container 17a is screwed with a lower part of the protecting member 13a via a screw portion 17b in a manner that the lower part of the protecting member 13a is suited for an upper base of the cylindrical container 17a. The electromagnetic field probe 2a may be configured with or with-out an electromagnetic wave absorbing member 16a that may be attached around the container 17a and may be removed.

The container 17a is five millimeters thick. The lower part of the protecting member 13a is ten millimeters thick. Each of the portions of the protecting member 13a and the container 17a has a dimension shown in FIG. 4. In the evaluation, the container 17a was filled with dielectric liquid having a real part of 40 of a dielectric constant on a frequency of approximately two GHz.

The electromagnetic wave absorbing member 15a has a complex dielectric constant including a real part of 100 and an imaginary part of 30 on the above frequency of approximately two GHz. The electromagnetic wave absorbing member 16a has a complex magnetic permeability including a real part of five and an imaginary part of ten on the above frequency of approximately two GHz.

A conventional electromagnetic field probe has a greater size than that of the electromagnetic field probe 2a for maintaining required measurement accuracy. In the evaluation, calculated was a correlation factor between a value of an electromagnetic field strength measured by the electromagnetic field probe 2a and a reference value measured by such a conventional electromagnetic field probe.

A correlation factor of 0.92 was obtained on a frequency of approximately 1.9 GHz, in a case where the electromagnetic field probe 2a was used with the electromagnetic wave absorbing member 16a. A correlation factor of 0.68 was obtained on the above frequency of approximately 1.9 GHz, in a case where the electromagnetic field probe 2a was used without the electromagnetic wave absorbing member 16a.

The value of the electromagnetic field strength measured by the electromagnetic field probe 2a with the electromagnetic wave absorbing member 16a shows a higher correlation with the reference value than the corresponding value measured without the electromagnetic wave absorbing member 16a. The above result supports the effect of im-proving the accuracy of measuring electromagnetic field strengths of the present invention.

According to the second embodiment described above, a suitable dielectric material may be selected to refill a container to form a dielectric member of an electromagnetic field probe according to a target or circumstances of measuring electromagnetic field strengths.

A third embodiment of the present invention will be described with reference to FIG. 5 showing a section of an electromagnetic field probe 3 of the third embodiment. Each of the portions given the reference numerals 11, 12, 13, 15 and 16 is a same as the corresponding one shown in FIG. 1, and its explanation is omitted. The electromagnetic field probe 3 has a dielectric member 14c corresponding to the dielectric member 14 shown in FIG. 1.

The dielectric member 14c is tapered near a lower end. This shape helps the dielectric member 14c be inserted into narrow spaces and be used to measure electromagnetic field strengths with the improved accuracy described in the previous embodiments.

The lower end of the dielectric member 14c may not be tapered as shown in FIG. 5, but may be variously shaped according to a target or circumstances of measuring electromagnetic field strengths. The dielectric member 14c may be formed by a container filled with dielectric liquid as described in the second embodiment.

According to the third embodiment described above, an electromagnetic field probe may adopt a dielectric member shaped suitable for a target or circumstances of measuring electromagnetic field strengths.

The particular hardware or software implementation of the present invention may be varied while still remaining within the scope of the present invention. It is therefore to be understood that within the scope of the appended claims and their equivalents, the invention may be practiced otherwise than as specifically described herein.

## Claims

1. An electromagnetic field probe (1; 2; 3) **characterized by** comprising:
an antenna (11);
a dielectric member (14) attached around the antenna (11); and
an electromagnetic wave absorbing member (16) attached around the dielectric member (14).

2. The electromagnetic field probe (1; 2; 3) defined in claim 1, wherein the dielectric member (14) has a dielectric constant being no less than 22 and no greater than 81, and a conductivity being no greater than 2.4 at a frequency of three Gigahertz.

3. The electromagnetic field probe (1; 2; 3) defined in claim 1, wherein the electromagnetic wave absorbing member (16) has a complex dielectric constant and a complex magnetic permeability, a real part of the complex dielectric constant being no less than one in a frequency range from one Megahertz to three Gigahertz, an imaginary part of the complex dielectric constant being no less than one in the frequency range, a real part of the complex magnetic permeability being no less than one and no greater than 100 in the frequency range, and an imaginary part of the complex magnetic permeability being no less than one and no greater than 50 in the frequency range.

4. The electromagnetic field probe (1; 2; 2a; 3) defined in claim 1, wherein the dielectric member (14) is formed by a container (17; 17a) configured to be filled with dielectric liquid (19).

5. The electromagnetic field probe (1; 2; 3) defined in claim 1, wherein the antenna (11) is variably placed relative to the dielectric member (14).
